# EUROPEAN PATENT SPECIFICATION

(11) **EP 3 220 325 B1**
(45) Date of publication and mention of the grant of the patent: **05.01.2022**
(21) Application number: 15858256.9
(22) Date of filing: 10.11.2015
(51) Int. Cl.: G01C 21/26, G01C 21/34, G06Q 90/00, G06Q 10/04, G06Q 10/06, G06F 30/22

(54) **EVACUATION PREDICTION SYSTEM, EVACUATION PREDICTION METHOD, AND COMPUTER-READABLE RECORDING MEDIUM**
EVAKUIERUNGSVORHERSAGESYSTEM, EVAKUIERUNGSVORHERSAGEVERFAHREN UND COMPUTERLESBARES AUFZEICHNUNGSMEDIUM
SYSTÈME DE PRÉDICTION D'ÉVACUATION, PROCÉDÉ DE PRÉDICTION D'ÉVACUATION ET SUPPORT D'ENREGISTREMENT LISIBLE PAR ORDINATEUR

(30) Priority: 14.11.2014 JP 2014231390
(43) Date of publication of application: 20.09.2017
(73) Proprietor: NEC Corporation, Tokyo 108-8001 (JP)
(72) Inventor: TADANO, Kumiko, Tokyo 108-8001 (JP)
(74) Representative: Vossius & Partner Patentanwälte Rechtsanwälte mbB
(86) International application number: PCT/JP2015/005612
(87) International publication number: WO 2016/075931

(56) References cited:
- EP-A1- 2 736 027
- JP-A- 2013 089 224
- JP-A- 2014 164 540
- US-A1- 2008 046 134
- TAKASHI MINAMOTO ET AL: "DEVELOPMENT OF TSUNAMI REFUGE PETRI-NET SIMULATION SYSTEM UTILIZABLE IN INDEPENDENCE DISASTER PREVENTION ORGANIZATION", PROCEEDINGS OF THE 14TH WORLD CONFERENCE ON EARTHQUAKE ENGINEERING, 17 October 2008 (2008-10-17), XP055481683,
- TAKASHI MINAMOTO ET AL.: 'DEVELOPMENT OF TSUNAMI EVACUATION SIMULATION SYSTEM AND ITS APPLICATION TO ASSESSMENT OF AREA REFUGE SAFETY' JOURNAL OF THE JAPAN SOCIETY OF CIVIL ENGINEERS A1 (STRUCTURAL ENGINEERING & EARTHQUAKE ENGINEERING vol. 65, no. 1, 01 January 2009, pages 757 - 767, XP003034338
- TORU FUTAGAMI ET AL.: 'Application Study of Petri Net Simulator for Human Evacuation Behavior Simulation', [Online] 01 January 2002, pages 1 - 4, XP003034339 Retrieved from the Internet: <URL:HTTP://WWW.JSCE.OR.JP/LIBRARY/OPEN/PRO C/MAGLIST2/00039/200211_NO26/PDF/330.PDF> [retrieved on 2015-01-15]
- None

## Description

### [Technical Field]

The present invention relates to an evacuation prediction system, an evacuation prediction method, and a computer-readable recording medium.

### [Background Art]

When a disaster occurs, there is a possibility that disaster victims who have suffered from the disaster are forced to evacuate from an area hit by the disaster. In such a case, it is desirable that the time required for the disaster victims who are required to evacuate (hereinafter referred to as "evacuees") to complete evacuation be as short as possible.

On the other hand, when a disaster occurs, a road network and the like that serve as evacuation paths sometimes suffer from the disaster and a road fault may occur. In this case, there is a possibility that the evacuation paths becomes unable to pass. Therefore, when an evacuation plan for evacuees is drawn up, there may be a case such that the state of damages and a recovery plan relating to the evacuation paths need to be considered. In addition, when a road network and the like that serve as evacuation paths are damaged by a disaster, there may be a case such that a recovery plan from a road fault having occurred to the road network and the like need to be drawn up so that the time required for disaster victims to evacuate becomes short. Furthermore, it is preferable that a recovery plan from troubles that have occurred to the road network and the like be made in accordance with a situation surrounding each disaster victim and a recovery status at each site where a trouble has occurred.

In PTL 1, an evacuation plan evaluation system and the like are disclosed. In the evacuation plan evaluation system disclosed in PTL 1, a support-requiring person count calculation unit calculates the number of persons who need support in evacuation based on attribute information of users of mobile terminals. In addition, an evacuation destination-classified evacuee count calculation unit calculates the number of evacuees who evacuate to their homes and an evacuation center. Furthermore, a simulation unit simulates for a case in which evacuees evacuate to their homes and the evacuation center from respective polygonal regions. Subsequently, a score calculation unit calculates scores for an evacuation plan based on the number of persons who need support, the number of evacuees, and a simulation result.

In PTL 2, a data processing device that is capable of predicting a destination even when there is a loss of current position data that are acquired in real time, is disclosed.

In PTL 3, an evacuation time prediction device that predicts evacuation time from a multistory building with stairs is disclosed.

US 2008/046134 A1 relates to ground transportation management, and in particular, to a method, apparatus, and article of manufacture for dynamically planning evacuation routes via ground transportation.

Takashi Minamoto et al.: "Development of Tsunami Refuge Petri-Net Simulation System Utilizable in Independence Disaster Prevention Organization", the 14th World Conference on Earthquake Engineering, 2008 relates to a method of tsunami refuge Petri-net simulation system in consideration of walking speed of each inhabitant, road blockage and method of questionnaire survey on attributes of inhabitants and houses.

JP-2013-089224 A relates to a refuge-from-tsunami supporting apparatus for supporting each user who carries a communication terminal in user's refuge travel from a tsunami.

### [Citation List]

### [Patent Literature]

[PTL 1] Japanese Unexamined Patent Application Publication Laid-open No. 2012-83908 A
[PTL 2] Japanese Unexamined Patent Application Publication Laid-open No. 2012-108748 A
[PTL 3] Japanese Unexamined Patent Application Publication Laid-open No. 2012-27560 A

### [Summary of Invention]

### [Technical Problem]

The evacuation plan evaluation system disclosed in PTL 1 and other systems do not necessarily take readability, reusability, expandability and others of a model used in simulation into consideration. That is, when the evacuation plan evaluation system disclosed in PTL 1 may have a difficulty in coping with various conditions relating to evacuation when estimating the time required for disaster victims to evacuate.

The present invention is accomplished to solve the above-described problem, and a principal object of the present invention is to provide an evacuation prediction system that may cope with various situations relating to evacuation when estimating the time required for disaster victims to evacuate.

### [Solution to Problem]

The present invention is defined by the features of the independent claims. The dependent claims relate to further aspects of the invention.

An evacuation prediction system in one aspect of the present invention includes model generating means for generating an evacuation sub-model representing evacuation paths that evacuees may pass in evacuation and a position of the evacuees on the evacuation paths and represented by a stochastic time Petri net, a recovery sub-model representing recovery status at each of trouble occurrence sites each of which is a site where a trouble occurred on the evacuation paths and represented by a stochastic time Petri net, and relation information representing a relation between the evacuation sub-model and the recovery sub-model based on evacuation information relating to the evacuation paths for the evacuees and recovery information relating to recovery timing at the trouble occurrence site and represented by an enabling function of the stochastic time Petri net, and analysis means for predicting time required for the evacuees to evacuate by analyzing the evacuation sub-model, the recovery sub-model, and the relation information.

An evacuation prediction method in one aspect of the present invention includes generating an evacuation sub-model representing evacuation paths that evacuees may pass in evacuation and a position of the evacuees on the evacuation paths and represented by a stochastic time Petri net, a recovery sub-model representing a recovery status at each of the trouble occurrence sites each of which is a site where a trouble occurred on the evacuation paths and represented by a stochastic time Petri net, and relation information representing a relation between the evacuation sub-model and the recovery sub-model based on information relating to the evacuation paths for the evacuees and information relating to recovery timing at the trouble occurrence site and represented by an enabling function of the stochastic time Petri net, and predicting time required for the evacuees to evacuate by analyzing the evacuation sub-model, the recovery sub-model, and the relation information.

A computer-readable recording medium in one aspect of the present invention comprising instructions which, when executed by a computer cause the computer to carry out: generating an evacuation sub-model representing an evacuation paths that evacuees may pass in evacuation and a position of the evacuees on the evacuation paths and represented by a stochastic time Petri net, a recovery sub-model representing a recovery status at each of trouble occurrence sites each of which is a site where a trouble occurred on the evacuation paths and represented by a stochastic time Petri net, and relation information representing a relation between the evacuation sub-model and the recovery sub-model based on information relating to the evacuation paths for the evacuees and information relating to recovery timing at the trouble occurrence site and represented by an enabling function of the stochastic time Petri net, and predicting time required for the evacuees to evacuate by analyzing the evacuation sub-model, the recovery sub-model, and the relation information.

### [Advantageous Effects of Invention]

According to the present invention, an evacuation prediction system that may cope with various situations relating to evacuation in estimating the time required for disaster victims to evacuate may be provided.

### [Brief Description of Drawings]

[Fig. 1] Fig. 1 is a diagram illustrating a configuration of an evacuation prediction system in a first example embodiment of the present invention;
[Fig. 2] Fig. 2 is a diagram illustrating an example of evacuation information and recovery information that are used in a model generating unit of the evacuation prediction system in the first example embodiment of the present invention;
[Fig. 3] Fig. 3 is a diagram illustrating the example of the evacuation information and the recovery information that are used in the model generating unit of the evacuation prediction system in the first example embodiment of the present invention;
[Fig. 4] Fig. 4 is a diagram illustrating another example of the evacuation information and the recovery information that are used in the model generating unit of the evacuation prediction system in the first example embodiment of the present invention;
[Fig. 5] Fig. 5 is a diagram illustrating still another example of the evacuation information and the recovery information that are used in the model generating unit of the evacuation prediction system in the first example embodiment of the present invention;
[Fig. 6] Fig. 6 is a diagram illustrating an example of evacuation sub-models and a recovery sub-model that are generated by the model generating unit of the evacuation prediction system in the first example embodiment of the present invention;
[Fig. 7] Fig. 7 is a diagram illustrating an example of relation information that is generated by the model generating unit of the evacuation prediction system in the first example embodiment of the present invention;
[Fig. 8] Fig. 8 is an example of the time required for evacuees to evacuate, which time was predicted by an analysis unit of the evacuation prediction system in the first example embodiment of the present invention;
[Fig. 9] Fig. 9 is an example of the time required for the evacuees to evacuate, which time was predicted by the analysis unit of the evacuation prediction system in the first example embodiment of the present invention;
[Fig. 10] Fig. 10 is another example of the time required for the evacuees to evacuate, which time was predicted by the analysis unit of the evacuation prediction system in the first example embodiment of the present invention;
[Fig. 11] Fig. 11 is still another example of the time required for the evacuees to evacuate that was predicted by the analysis unit of the evacuation prediction system in the first example embodiment of the present invention;
[Fig. 12] Fig. 12 is a flowchart illustrating an operation of the evacuation prediction system in the first example embodiment of the present invention; and

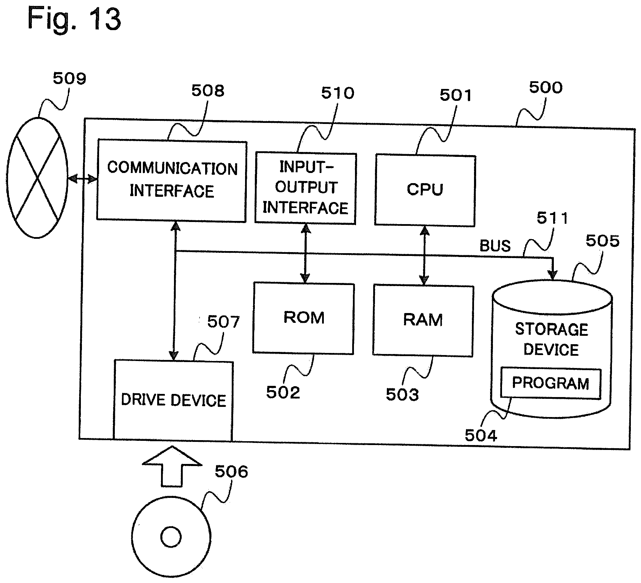

[Fig. 13] Fig. 13 is a diagram illustrating an example of an information processing unit that achieves the evacuation prediction systems and the like in the respective example embodiments of the present invention.

### [Description of Embodiments]

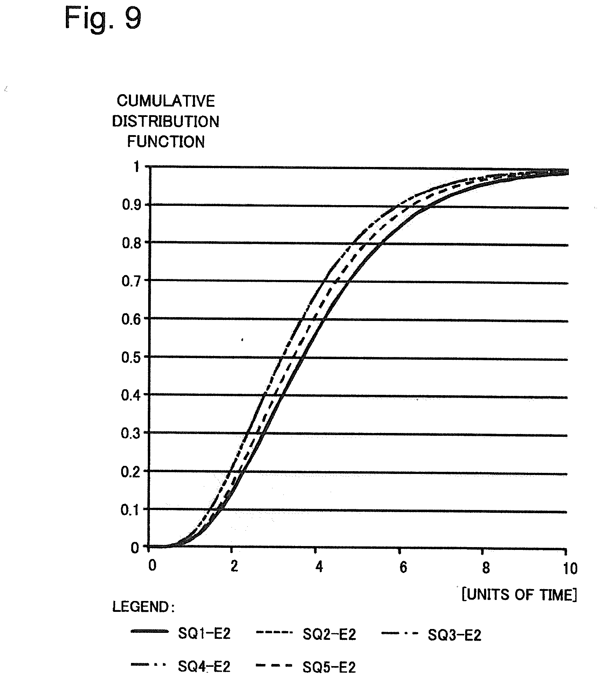

Respective example embodiments of the present invention will be described with reference to the accompanying drawings. In the respective example embodiments of the present invention, each component in respective devices exhibits a block in a functional unit. Each component in the respective devices may be implemented by any combination of, for example, an information processing device 500 as illustrated in Fig. 9 and software. As an example, the information processing device 500 includes a configuration as described below.

- A CPU (Central Processing Unit) 501
- ROM (Read Only Memory) 502
- RAM (Random Access Memory) 503
- A program 504 loaded into the RAM 503
- A storage device 505 storing the program 504
- A drive device 507 reading and writing from/to a storage medium 506
- A communication interface 508 connecting to a communication network 509
- An input-output interface 510 inputting and outputting of data
- A bus 511 connecting the respective components Methods for implementing the respective devices include various modifications. For example, each device may be achieved as a dedicated device. Each device may also be implemented by a combination of a plurality of devices.

In the drawings illustrating the configurations of respective devices and respective systems, the directions of arrows in the drawings only illustrate an example and do not limit the directions of signals exchanged among the components.

### (First Example Embodiment)

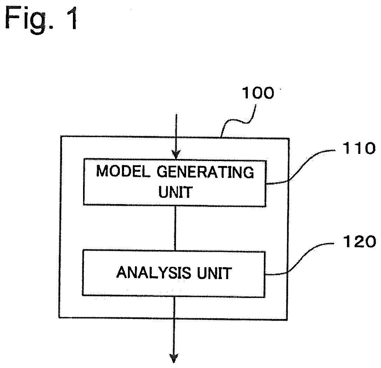

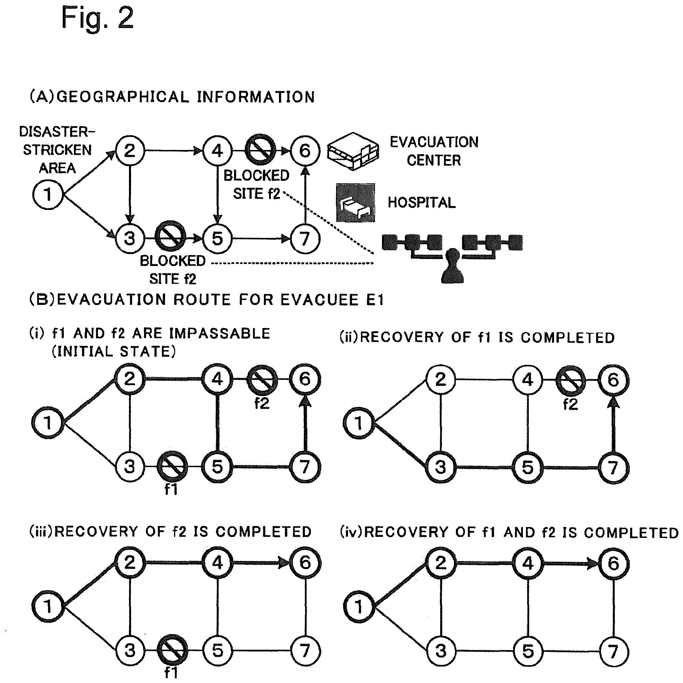

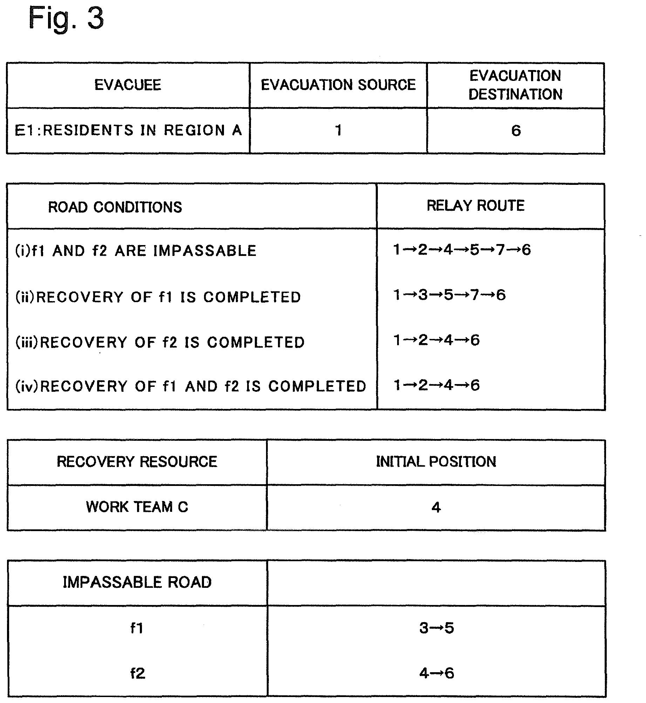

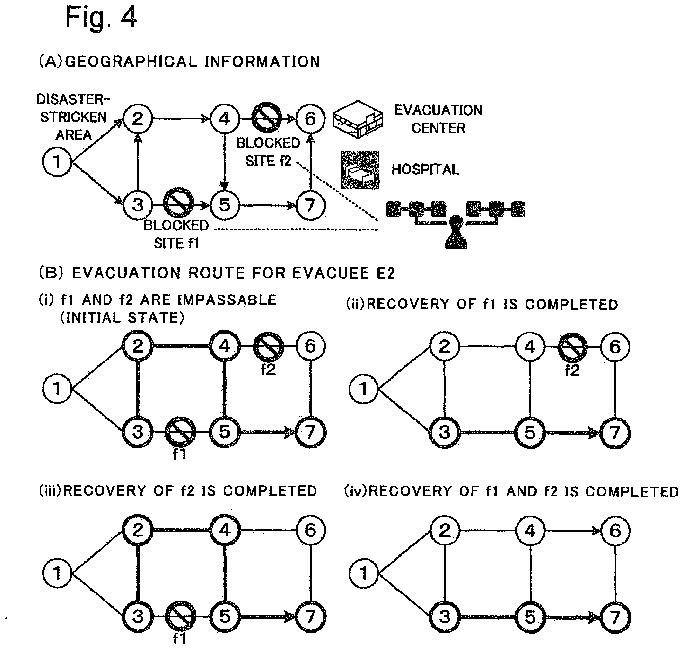

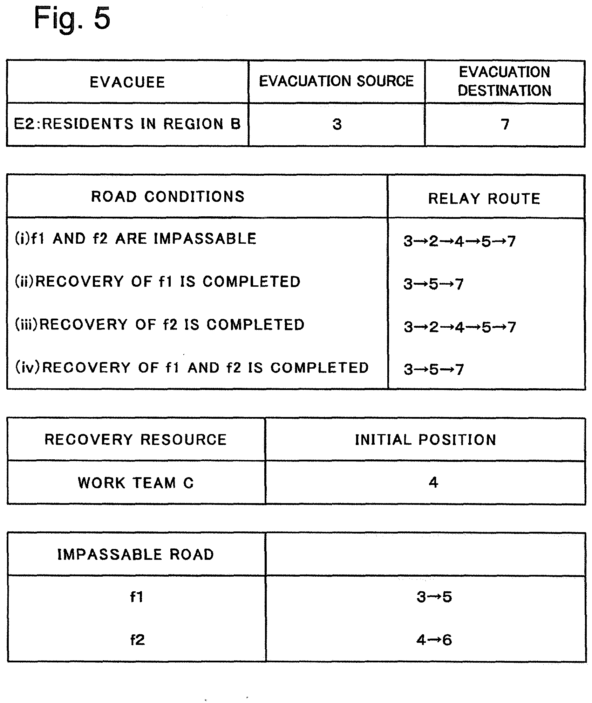

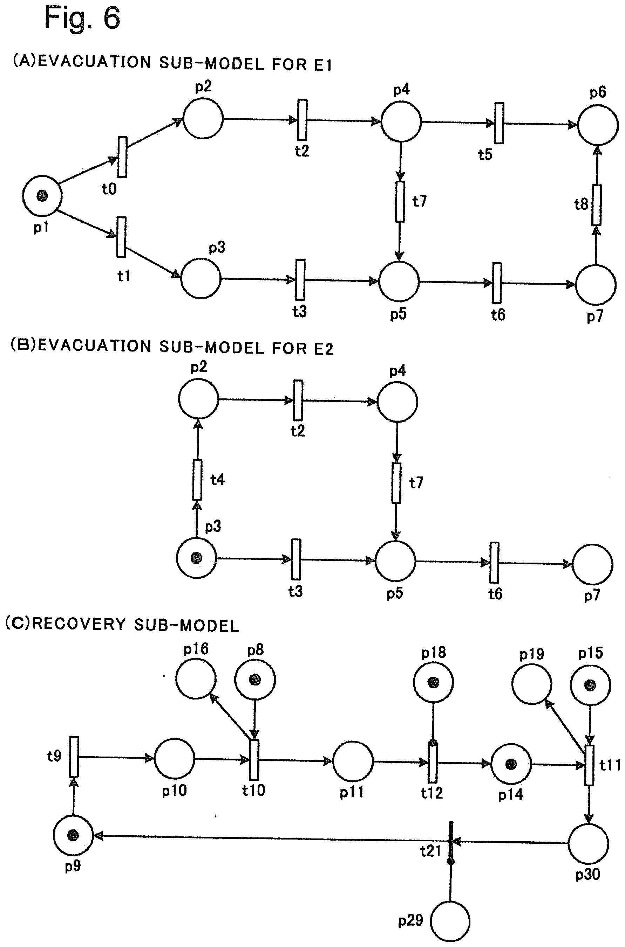

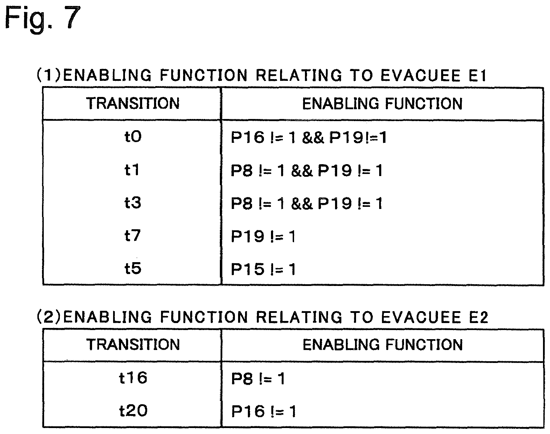

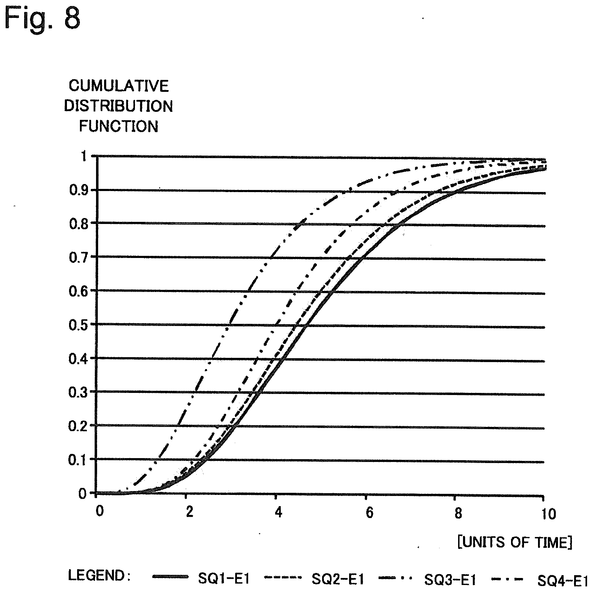

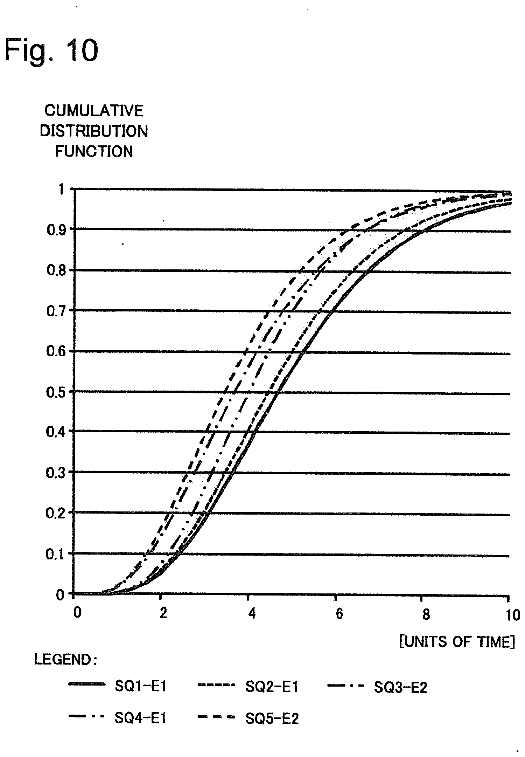

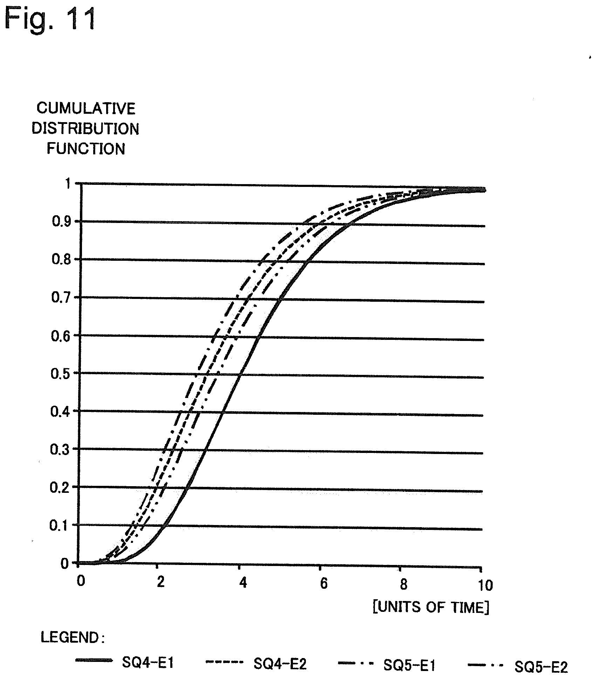

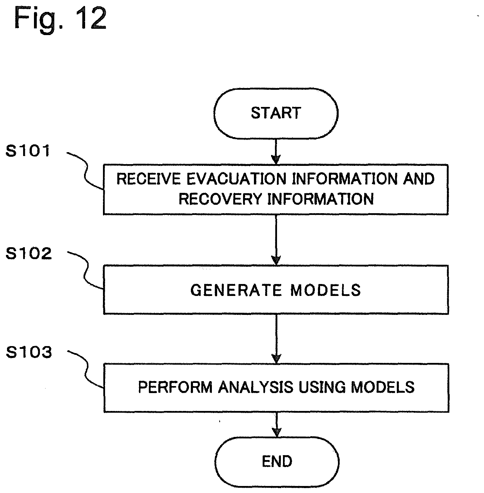

First, a first example embodiment of the present invention will be described. Fig. 1 is a diagram illustrating a configuration of an evacuation prediction system in the first example embodiment of the present invention. Fig. 2 is a diagram illustrating an example of evacuation information and recovery information that are used in a model generating unit of the evacuation prediction system in the first example embodiment of the present invention. Fig. 3 is a diagram illustrating the example of the evacuation information and the recovery information that are used in the model generating unit of the evacuation prediction system in the first example embodiment of the present invention. Fig. 4 is a diagram illustrating another example of the evacuation information and the recovery information that are used in the model generating unit of the evacuation prediction system in the first example embodiment of the present invention. Fig. 5 is a diagram illustrating still another example of the evacuation information and the recovery information that are used in the model generating unit of the evacuation prediction system in the first example embodiment of the present invention. Fig. 6 is a diagram illustrating an example of evacuation sub-models and a recovery sub-model that are generated by the model generating unit of the evacuation prediction system in the first example embodiment of the present invention. Fig. 7 is a diagram illustrating an example of relation information that is generated by the model generating unit of the evacuation prediction system in the first example embodiment of the present invention. Fig. 8 is an example of the time required for evacuees to evacuate, which time was predicted by an analysis unit of the evacuation prediction system in the first example embodiment of the present invention. Fig. 9 is an example of the time required for the evacuees to evacuate, which time was predicted by the analysis unit of the evacuation prediction system in the first example embodiment of the present invention. Fig. 10 is another example of the time required for the evacuees to evacuate, which time was predicted by the analysis unit of the evacuation prediction system in the first example embodiment of the present invention. Fig. 11 is still another example of the time required for the evacuees to evacuate that was predicted by the analysis unit of the evacuation prediction system in the first example embodiment of the present invention. Fig. 12 is a flowchart illustrating an operation of the evacuation prediction system in the first example embodiment of the present invention.

As illustrated in Fig. 1, an evacuation prediction system 100 in the first example embodiment of the present invention includes a model generating unit 110 and an analysis unit 120. The model generating unit 110 generates an evacuation sub-model, a recovery sub-model, and relation information based on evacuation information relating to evacuation paths for evacuees and recovery information relating to recovery timing at a trouble occurrence site that is a site where a trouble occurred in the evacuation paths. The analysis unit 120 predicts time required for the evacuees to evacuate by analyzing the evacuation sub-model, the recovery sub-model, and the relation information.

The evacuation sub-model represents the evacuation paths that are a road network and others that the evacuees may pass in evacuation and a position of the evacuees on the evacuation paths. The recovery sub-model represents a recovery plan for the trouble occurrence site and a recovery status at the respective trouble occurrence site. The relation information represents a relation between the evacuation sub-model and the recovery sub-model.

First, the model generating unit 110 will be described. In the evacuation prediction system 100 of the present example embodiment, a stochastic time Petri net (hereinafter referred to as "sTPN") is used as the model generated by the model generating unit 110.

As an example, an sTPN is represented as a tuple <P, T, A-, A+, A·, m0, EFT, LFT, F, C, E, L>. The respective elements of the tuple are represented by a predetermined drawing (not illustrated). P is a set of places. In a drawing illustrating an sTPN, a place is represented by an unfilled circle. T is a set of transitions. In a drawing illustrating an sTPN, a transition is represented by an unfilled rectangle or a bar. A-denotes input arcs each of which connects a place and a transition in a direction from the place to the transition. A+ denotes output arcs each of which connects a place and a transition in a direction from the transition to the place. In the following description, input arcs and output arcs may be simply referred to as arcs in a collective manner. In a drawing illustrating an sTPN, an arc is represented by an arrow. A· denotes inhibitor arcs each of which connects a place and a transition in a direction from the place to the transition. In a drawing illustrating an sTPN, an inhibitor arc is represented by an arrow with a circular tip.

In addition, m0 is an initial marking representing the non-negative numbers of tokens at the respective places. In a drawing illustrating an sTPN, a token is represented by a black dot placed inside a place. EFT and LFT respectively are earliest firing time and latest firing time at the respective transitions included in T. EFT is a non-negative real number including zero. LFT is a non-negative real number, including zero and infinity. A value of LFT is equal to or larger than a corresponding value of EFT. F denotes cumulative distribution functions of firing times of the respective transitions included in T. The firing times are located between EFT and LFT.

C denotes weights each of which, represents the probability of firing relating to one of a plurality of transitions that are enabled to fire when the plurality of transitions are enabled to fire simultaneously,. C is assigned to transitions that may be enabled to fire simultaneously. E denotes enabling functions that are associated with markings for the respective transitions included in T. L (flushing functions) is assigned to transitions. When a transition to which L is assigned fires, a token in a place that is related with the transition by L is flushed regardless of whether the place has a connection relation by an arc with the transition.

A transition is assumed to be firable when the following conditions are satisfied. When the transition fires, a token is removed from a place connected to the transition via an input arc, and a token is added to a place connected to the transitions via an output arc.
- One or more tokens exist in all the places connected to the transition via input arcs.
- No token exists in any of the places connected to the transition via inhibitor arcs.
- The time is larger than the value of EFT and smaller than the value of LFT.
- An associated enabling function becomes true.

Details of the sTPN are described in, for example, "Vicario, E., Sassoli, L., and Carnevali, L. (2009) 'Using stochastic state classes in quantitative evaluation of dense-time reactive systems', IEEE Transactions on Software Engineering, Vol. 35, No. 5, pp. 703-719." and other references.

### (Generation of Evacuation Sub-model)

An example of generation of the sub-models and other models by the model generating unit 110 will be described below. First, an example of generation of an evacuation sub-model by the model generating unit 110 will be described. The model generating unit 110 generates the evacuation sub-model by using an sTPN, as described below.

In this case, the model generating unit 110 generates an evacuation sub-model in units of individuals who are required to evacuate, for example. The model generating unit 110 may, however, generates the evacuation sub-model in units of groups of evacuees instead of individuals. For example, the model generating unit 110 generates the evacuation sub-model with respect to each group of individuals required to evacuate in a local area. Further, the model generating unit 110 may generate an evacuation sub-model with respect to each group of evacuees who have any given attribute, such as the injured, the sick, and persons engaging in a specific profession. In other words, the model generating unit 110 may generate an evacuation sub-model with respect to each group of evacuees who are in a predetermined condition as described above.

The model generating unit 110 receives evacuation information relating to evacuation paths for the evacuees when generating the evacuation sub-model. That is, when the evacuation sub-model is generated, an input to the model generating unit 110 is the evacuation information. The evacuation information includes, for example, geographical information related to the evacuation paths and other paths, an evacuation origin, an evacuation destination, and information relating to evacuation routes that are routes that the evacuees may pass depending on recovery status of the evacuation paths.

Among the evacuation information, the geographical information related to the evacuation paths is represented in a form as a directed graph illustrated in Fig. 2 (A), for example. In the graph, areas and locations at which the evacuees may stay are represented as nodes. For example, an area indicated by a node that is a circle with a number 1 or 2 is a disaster-stricken area. An area indicated by a node assigned a number 6 or 7 is an area that serves as a candidate for an evacuation destination.

In this graph, a road network that connects the areas at which the evacuees may stay to one another and may serve as the evacuation paths is represented by arrows as links. The directions of the arrows are determined in accordance with directions in which the evacuees evacuate and the like. When there is a site where a trouble has occurred on the road network (hereinafter referred to as "trouble occurrence site"), information indicating the occurrence of trouble is provided to a position corresponding to the trouble occurrence site on an arrow as needed basis. In the example illustrated in Fig. 2 (A), it is assumed that troubles have occurred at two sites f1 and f2 in the road network and the two sites are impassable.

Among the evacuation information, the evacuation origin and evacuation destination and information relating to the evacuation routes are represented as in Fig. 2 (B). Fig. 2 (B) illustrates an evacuation origin, an evacuation destination, and information relating to evacuation routes with respect to evacuees E1. In this example, the evacuee E1 is assumed to evacuate from the area corresponding to the node with number 1 to the area corresponding to the node with number 6 in Fig. 2 (A). The evacuee E1 is also assumed to evacuate using one of evacuation routes illustrated in (i) to (iv) in Fig. 2 (B) depending on recovery status at f1 and f2, which are trouble occurrence sites.

In addition to the above, the evacuation information includes information relating to the time required for evacuation, which is not illustrated, such as transit time to pass each evacuation path, the number of evacuees whom each area is capable of accommodating, the capacity of each evacuation path (for example, the number of persons who are able to pass per unit of time), and the like.

Among the evacuation information, the evacuation origin, the evacuation destination and the information relating to the evacuation routes may also be represented in a form as illustrated in Fig. 3. The numbers in Fig. 3 correspond to the positions of the numbers assigned to the nodes in the graphs indicating the evacuation paths in Fig. 2.

An example of another evacuation information is illustrated in Fig. 4 and Fig. 5. As illustrated in Fig. 4 (A), geographical information in this example is the same as that in the example in Fig. 2 (A). In addition, as illustrated in Fig. 4 (B), evacuee E2 is assumed to evacuate from an area corresponding to a node to which a number 3 is assigned to the area corresponding to the node to which the number 7 is assigned in Fig. 4 (A). The evacuee E2 is also assumed to evacuate using one of evacuation routes illustrated in (i) to (iv) in Fig. 4 (B) depending on recovery status at f1 and f2, which are trouble occurrence sites.

As with Fig. 3, the evacuation origin, the evacuation destination and information on the evacuation routes illustrated in Fig. 4 are also represented in a form as illustrated in Fig. 5.

The model generating unit 110 generates the evacuation sub-model based on the evacuation information as described below, for example. The model generating unit 110 generates, in the evacuation sub-model, models that represent the areas and others corresponding to the nodes in the geographical information, which serve as the evacuation paths. The model generating unit 110 represents the models as places. The model generating unit 110 may generate, in the evacuation sub-model, information of the areas corresponding to all the nodes included in the geographical information. The models of the areas generated as the evacuation sub-model (the areas represented by the places when an sTPN is used) are appropriately determined in accordance with regions indicated by the geographical information, evacuation routes, and the like.

The model generating unit 110 generates, in the evacuation sub-model, information representing connection relations in the geographical information, which serve as the evacuation paths. The model generating unit 110 represents the information as arcs each of which connects a transition, a place corresponding to a connection source and a transition, and as arcs each of which connects a transition and a place corresponding to a connection destination. The directions of the arcs are the same as the directions in the evacuation routes, for example.

The model generating unit 110 further generates models relating to travel time on the evacuation routes and probability distributions thereof in accordance with characteristics of the travel time as elements in the evacuation sub-model. With an sTPN being used for the evacuation sub-model, the model generating unit 110 may represent the above information by assigning earliest firing time, latest firing time, cumulative distribution function, and the like to corresponding transitions.

Last, the model generating unit 110 generates a model representing an initial position of the evacuees as an element of the evacuation sub-model. The model generating unit 110 represents the model by distributing a token in a place corresponding to the initial position of the evacuees.

The model generating unit 110 may select areas and a road network the information of which is necessary for obtaining the time required for the evacuees to evacuate out of the information included in the geographical information to generate the evacuation sub-model. In other words, when areas and a road network that the evacuees may pass in evacuation are limited to specific ones, the model generating unit 110 may exclude information relating to areas and a road network that are not included in the evacuation paths for the evacuees to generate the evacuation sub-model.

Examples of the areas, the road network, and others that are excluded from the evacuation sub-model include an area, a road network and others that are distant from and do not serve as the evacuation paths for the evacuees. There is also a case in which a road network and the like that are relatively narrow and require a long time to pass are excluded from the evacuation sub-model when a lot of evacuees are involved, the distance to the evacuation destination is long, and the like. In addition to the above, there is a case in which a road network that require a long time to be recovered and are expected to be difficult to recover within the time required to complete evacuation and the like are excluded from the evacuation sub-model. The information described above may be excluded in advance from the evacuation information that is input to the model generating unit 110.

The model generating unit 110 may store the above-described generation rules in a not-illustrated storage unit in advance and refer to the generation rules to generate a model when generating the model. When generating a model, the model generating unit 110 may also acquire the generation rules from the outside as needed basis to generate the model.

Fig. 6 (A) and Fig. 6 (B) illustrate examples of evacuation sub-models. The model generating unit 110 generates the evacuation sub-model in Fig. 6 (A) with respect to the evacuee E1 in Fig. 2. The model generating unit 110 generates the evacuation sub-model in Fig. 6 (B) with respect to the evacuee E2 in Fig. 4.

In the evacuation sub-models illustrated in Fig. 6 (A) and Fig. 6 (B), places p1 to p7 respectively correspond to the nodes 1 to 7 with the same numbers illustrated in Fig. 2 and Fig. 4. In the evacuation sub-models illustrated in Fig. 6 (A) and Fig. 6 (B), transitions t0 to t6 and arcs connected to the transitions correspond to the arrows illustrated in Fig. 2 and Fig. 4. In each of the evacuation sub-models illustrated in Fig. 6 (A) and Fig. 6 (B), only areas and a road network that may serve as evacuation routes are represented as models.

### (Generation of Recovery Sub-model)

Next, an example of generation of a recovery sub-model by the model generating unit 110 will be described. The model generating unit 110 generates the recovery sub-model by using an sTPN as described below.

In this case, the model generating unit 110 generates a recovery sub-model with respect to each recovery plan, for example. When a plurality of the recovery plans are devisable depending on sequences of recovery or corresponding to respective trouble occurrence sites to be recovered, the model generating unit 110 may generate a recovery sub-model for each of the plurality of the recovery plans.

In generating the recovery sub-model, the model generating unit 110 receives recovery information relating to the evacuation paths for the evacuees. In other words, when the recovery sub-model is generated, an input to the model generating unit 110 is the recovery information. The recovery information includes, for example, operations for recovery and a sequence thereof. The operations for recovery include, for example, recovery work itself at a trouble occurrence site and movements of a recovery resource engaging in the recovery. The sequences of recovery include a case in which a single recovery resource carries out recovery sequentially and a case in which a plurality of recovery resources carry out recovery in parallel. The recovery information may further include information relating to not-illustrated changes in the time required for evacuation, such as changes in the time required to pass an evacuation path and changes in the capacity of an evacuation path depending on information of a trouble.

The model generating unit 110 generates the recovery sub-model based on the recovery information as described below, for example. The model generating unit 110 generates, in the recovery sub-model, a model representing an initial state in a recovery plan. With an sTPN being used for the recovery sub-model, the model generating unit 110 generates a place representing the initial state and places one token in the place in this case.

The model generating unit 110 generates models representing respective operations for recovery as elements in the recovery sub-model. With an sTPN being used for the recovery sub-model, the model generating unit 110 generates a transitions, a places, and arcs that connects the transition and the place to represent the respective operations for recovery. In this case, firing of the transition represents progresses of the corresponding operations for recovery.

The model generating unit 110 generates the recovery sub-model so that the recovery sub-model represents a sequence of recovery. With an sTPN being used for the recovery sub-model, the model generating unit 110 represents the sequence of recovery by means of connecting the place representing the initial state and the above-described transitions, places, and arcs, which represent the operations for recovery, in accordance with the sequence of recovery. In this case, transitions, places, and arcs for connections are generated as needed basis.

The token placed in the place representing the initial state, when a transition that is a connection destination connected thereto fires, move from the transition to a place connected by an output arc. The action indicates that the operation for recovery and others has been carried out.

The model generating unit 110 further generates the recovery sub-model so that the recovery sub-model represent the time required for recovery at each of the trouble occurrence sites, reliability of the time required for recovery (possibility of causing recovery work to be redone and other possibilities), and movement time of the recovery resource. The model generating unit 110 may generate the recovery sub-model so as to represent the above-described periods of time as probability distributions. With an sTPN being used for the recovery sub-model, the model generating unit 110 may represent these pieces of information by assigning earliest firing time, latest firing time, a cumulative distribution function, and the like to corresponding transitions.

With respect to a portion of the recovery sub-model to be generated that indicate each recovery operation carried out at the trouble occurrence site, the model generating unit 110 generates the recovery sub-model so that the recovery sub-model indicate a state representing the recovery status of the trouble occurrence site. With an sTPN being used for the recovery sub-model, the model generating unit 110 generates places representing a state indicating that a trouble has not been recovered (troubled state) and a state indicating that the trouble has been recovered (recovered state), respectively, to each portion representing a recovery operation. The respective places are connected to a transition representing the operation for recovery. At the initial state, a token is placed in the place representing the troubled state. A firing of the transition connected to the newly generated place cause the token to move from the place representing the troubled state to the place representing the recovered state.

The model generating unit 110 may configure the recovery sub-model so that the recovery sub-model explicitly indicate the completion of the final step in a recovery plan (that is, the completion of recovery work). Generating the recovery sub-model in this way prevents incorrect analysis and enables the finish of analysis to be easily recognized when the recovery sub-model is analyzed by the analysis unit 120. With an sTPN being used for the recovery sub-model, the model generating unit 110 generates a model in which an inhibitor arc is connected to a transition that is connected to a place representing the completion of the last step in the recovery plan by an input arc, in one example,.

The model generating unit 110 does not have to generate the elements as described above. With an sTPN being used for the recovery sub-model, the model generating unit 110, for example, generates a model so as not to connect a place representing the completion of the last step to other transitions.

Fig. 6 (C) illustrates an example of a recovery sub-model when an sTPN is used. The model generating unit 110 generates the recovery sub-model in Fig. 6 (C) with respect to recovery of evacuation paths for the evacuee E1 in Fig. 2 and the evacuee E2 illustrated in Fig. 4. In the evacuation sub-model illustrated in Fig. 6 (C), the evacuation sub-model is generated assuming that, with respect to the trouble occurrence sites f1 and f2 illustrated in Fig. 2 or Fig. 4, f2 is recovered first and subsequently f1 is recovered.

In the recovery sub-model illustrated in Fig. 6 (C), transitions t10 and t11 are transitions respectively representing work for recovery with respect to the trouble occurrence sites f1 and f2. Transition t9 is a transition representing a migration of a recovery resource between the trouble occurrence sites f1 and f2. To each of the transitions t9 to t11, an earliest firing time, a latest firing time, a cumulative distribution function, and others are assigned in accordance with the time required for recovery and the like related to the transition. Places p8 and p15 are places respectively indicating that the trouble occurrence sites f1 and f2 are in troubled states. Places p16 and p19 are places respectively indicating that the trouble occurrence sites f1 and f2 are in recovered state.

### (Generation of Relation Information)

Next, an example of generation of relation information by the model generating unit 110 will be described. The model generating unit 110 generates the relation information by using an sTPN, as described below.

As described afore, the relation information represents a relation between an evacuation sub-model and a recovery sub-model. Therefore, the model generating unit 110 generates a piece of relation information in accordance with the number of the evacuation sub-models and the recovery sub-models both of which are generated.

In generating the relation information, the model generating unit 110 receives information relating to operations for recovery included in the above-described recovery information and a trouble occurrence site that is subjected to the operations for recovery. In other words, when a recovery sub-model is generated, an input to the model generating unit 110 is the information described above.

The relation information, as an example, determines relation between routes taken by the evacuees in the evacuation sub-model and recovery status relating to the trouble occurrence site in the recovery sub-model. In other words, the relation information is set so that, when a plurality of evacuation route candidates exists and an evacuation route to be taken may be changed depending on recovery status at the trouble occurrence site, an evacuation route taken by the evacuees is selected depending on the recovery status at the trouble occurrence site. The relation information is represented so that, when a plurality of transitions are connected to a place via output arcs, a transition corresponding to a selected path is enabled to fire. The model generating unit 110 represents the relation information as an enabling function of the sTPN.

As another example, when an evacuation path of which a plurality of evacuees are unable to pass at the same time exists, the model generating unit 110 may determine, as the relation information, a passing order of the plurality of evacuees through the evacuation path. In other words, the model generating unit 110 may generate a model that represents a constraint in which, when an evacuee is passing the evacuation path, another evacuee is unable to pass the evacuation path. In this case, the model generating unit 110 may represent such information by using an enabling function of the sTPN.

Fig. 7 illustrates an example of relation information in the case of using sTPN for representing the evacuation sub-models and the recovery sub-model. The model generating unit 110 generates the relation information illustrated in Fig. 7 with respect to the evacuee E1 in Fig. 2 and the evacuee E2 illustrated in Fig. 4. Regarding the evacuee E1, the relation information is generated so that a transition enabled to fire in the recovery sub-model may change depending on recovery status at f1 and f2 which are the trouble occurrence sites. Regarding the evacuee E2, the relation information is generated so that a transition enabled to fire in the recovery sub-model may change depending on recovery status at f1 which is the trouble occurrence site.

Subsequently, the analysis unit 120 will be described. The analysis unit 120 predicts time required for the evacuees to evacuate by using the models generated by the model generating unit 110. With respect to the evacuation sub-model, recovery sub-model, and relation information generated by the model generating unit 110, the analysis unit 120 predicts the time required for the evacuees to evacuate by carrying out a state traversal over states from an initial state to a state when the evacuees reach an evacuation destination, and the like.

With models using sTPN being generated as the models, the analysis unit 120 may use, for example, the time required for a token starting from the initial state to reach a place representing the evacuation destination in the evacuation sub-model as the time required for the evacuees to evacuate. When obtaining the above-described time, the analysis unit 120 may use any state traversal algorithm for an sTPN, including known methods.

The time required for the evacuees to evacuate predicted by the analysis unit 120 may be output in any method and form. The time required for the evacuees to evacuate is represented by, for example, a cumulative distribution function of a time at which evacuation is completed.

Each of Fig. 8 to Fig. 11 illustrates an example of the above-described cumulative distribution functions relating to the time required for the evacuees E1 or E2 to evacuate. In these drawings, SQ1 to SQ5 indicate sequences of recovery at f1 and f2, both of which are trouble occurrence sites.
- SQ1: f1 and f2 have not been recovered.
- SQ2: only recovery of f2 has been completed.
- SQ3: only recovery of f1 has been completed.
- SQ4: f1 has been recovered first, and subsequently f2 has been recovered.
- SQ5: f2 has been recovered first, and subsequently f1 has been recovered.

Fig. 8 illustrates an example of cumulative distribution functions relating to the time required for the evacuee E1 to evacuate. It is evident that the time required for the evacuee E1 to evacuate varies depending on the sequences of recovery.

Fig. 9 illustrates an example of cumulative distribution functions relating to the time required for the evacuee E2 to evacuate. In this case, with regard to the recovery sequences SQ3 and SQ4, cumulative distribution functions relating to the time required for the evacuee E2 to evacuate are identical. With regard to the recovery sequences SQ1 and SQ2, cumulative distribution functions relating to the time required for the evacuee E2 to evacuate are identical. This is because, as also illustrated in Fig. 4, recovery at the trouble occurrence site f2 does not influence the evacuation routes for the evacuee E2.

Fig. 10 illustrates an example in which, with respect to each of the recovery sequences SQ1 to SQ5, a cumulative distribution function relating to the longer time required for evacuation is selected out of cumulative distribution functions relating to the time required for the evacuees E1 and E2 to evacuate and illustrated. According to Fig. 10, it is evident that selecting the recovery sequence SQ5 is preferable in order to reduce the distribution of the time required for evacuation.

Fig. 11 illustrates cumulative distribution functions relating to the time required for the evacuees E1 and E2 to evacuate when both f1 and f2, which are trouble occurrence sites, are recovered. According to Fig. 11, the case in which the time required for evacuation is likely to be the longest is a case when SQ5 is selected as the recovery sequence.
However, with regard to the evacuee E2, when the recovery sequence SQ5 is selected, the time required for evacuation becomes short. As described above, according to Fig. 11, it is evident that, when there is a difference in the priority of evacuation between the evacuees E1 and E2, it is possible to reduce the time required for the evacuees with a higher priority to evacuate by appropriately selecting a recovery sequence.

In other words, when a plurality of the recovery sequences are applicable, the evacuation prediction system 100 in the present example embodiment may predict the time required for the evacuees to evacuate for each of the plurality of the recovery sequences. It is evident that, based on results from prediction of the times required for the evacuees to evacuate for respective ones of the plurality of recovery sequences, it is possible to make a recovery plan in accordance with situations relating to the evacuees, including the priority of evacuation, for example.

Subsequently, using Fig. 12, an example of an operation of the evacuation prediction system 100 in the present example embodiment will be described. The model generating unit 110 first receives evacuation information and recovery information (step S101). For example, the model generating unit 110 receives the evacuation information and the recovery information in a form as illustrated in the above-described Fig. 3. The model generating unit 110 may receive the information described above via any inputting means and the like. The model generating unit 110 may use information stored in any storage means in advance, such as a memory, a disk or other devices. A prediction unit 110 may receive the information described above via a communication network.

Subsequently, the model generating unit 110 generates an evacuation sub-model, a recovery sub-model and evacuation information based on the received evacuation information and recovery (step S102). The generated respective sub-models and other models are appropriately stored in a storage means, such as a memory, a disk or other devices which is not illustrated, so as to be referred by the analysis unit 120.

When the respective sub-models or other models are generated, the analysis unit 120 predicts the time required for evacuees to evacuate by analyzing the generated models (step S103). Predicted results are indicated as in, for example, Fig. 8 to Fig. 11 described above. The results from the prediction by the analysis unit 120 are output from any outputting means, including a display device or others, or a communication network. The results from the prediction by the prediction unit 110 may be stored in any storage means so as to be referenced when necessary.

As described thus far, the evacuation prediction system 100 in the present example embodiment generates an evacuation sub-model, a recovery sub-model, and recovery information based on evacuation information relating to evacuation paths for evacuees and recovery information relating to recovery timing at a site where a trouble has occurred in the evacuation paths. The evacuation prediction system 100 in the present example embodiment predicts the time required for the evacuees to evacuate using the generated models.

In the present example embodiment, a plurality of sub-models are generated by the model generating unit 110 in accordance with details to be modeled. Therefore, the models generated by the model generating unit 110 have a higher readability than a model generated in a case where a single model representing details included in the respective sub-models is generated. In addition, when there is a change in evacuees or a recovery plan for a trouble occurrence site, a plurality of sub-models being generated by the model generating unit 110 in accordance with details to be modelled enables the models to be modified easily to cope with the change. Thus, the models generated by the model generating unit 110 have a high expandability with respect to the generated models. Therefore, the evacuation prediction system 100 in the present example embodiment may cope with various situations relating to evacuation in estimating the time required for disaster victims to evacuate.

When a disaster occurs, various recovery plans, such as determining a sequence of recovery for trouble occurrence sites and carrying out recovery work for a plurality of trouble occurrence sites at the same time, are expected to be made. The evacuation prediction system 100 in the present example embodiment may predict the time required for the evacuees to evacuate for each of such different recovery plans. Therefore, the evacuation prediction system 100 in the present example embodiment may determine a recovery plan in which the time required for the evacuees to evacuate satisfies a predetermined condition by predicting the times required for the evacuees to evacuate in respective cases in which the different recovery plans are executed. The predetermined conditions in this case include, for example, completing evacuation within a predetermined period of time, having the shortest time required for evacuation among executable recovery plans, and other conditions. In other words, the evacuation prediction system 100 in the present example embodiment may also be used as a system for determining a recovery plan.

In the present example embodiment, with TPN being used as models, the model generating unit 110 may generate the models by using a rule different from the above-described generation rules. As an example, the model generating unit 110 may generate the models by using a rule different from the above-described generation rules, such as not using any inhibitor arc when modeling whether a road is passable depending on progress stages of recovery relating to a trouble occurrence site.

In addition, in the present example embodiment, the evacuation information and the recovery information that the model generating unit 110 receives may be different from the above-described examples. The model generating unit 110 may appropriately receive any information that is necessary for generating respective sub-models and the like.

Furthermore, in the present example embodiment, the model generating unit 110 and the analysis unit 120 may be achieved as a single device or as separate devices. When the model generating unit 110 and the analysis unit 120 are achieved as separate devices, the model generating unit 110 and the analysis unit 120 are interconnected via, for example, a wired or wireless communication network. The model generating unit 110 and the analysis unit 120 may exchange data representing respective sub-models and others with each other via a file.

The present invention was described above through example embodiments thereof, but the present invention is not limited to the above example embodiments. Various modifications that could be understood by a person skilled in the art may be applied to the configurations and details of the present invention within the scope of the present invention. The configurations in the respective example embodiments may be combined with one another without departing from the scope of the present invention.

This application claims priority based on Japanese Patent Application No. 2014-231390, filed on Nov. 14, 2014.

### [Reference signs List]

- 100: Evacuation prediction system
- 110: Model generating unit
- 120: Analysis unit
- 500: Information processing unit
- 501: CPU
- 502: ROM
- 503: RAM
- 504: Program
- 505: Storage device
- 506: Storage medium
- 507: Drive device
- 508: Communication interface
- 509: Communication network
- 510: Input-output interface
- 511: Bus

## Claims

1. An evacuation prediction system (100), comprising:
model generating means (110) for generating an evacuation sub-model representing evacuation paths that evacuees may pass in evacuation and a position of the evacuees on the evacuation paths and represented by a stochastic time Petri net, a recovery sub-model representing recovery status at each of trouble occurrence sites each of which is a site where a trouble occurred on the evacuation paths and represented by a stochastic time Petri net, and relation information representing a relation between the evacuation sub-model and the recovery sub-model based on evacuation information relating to the evacuation paths for the evacuees and recovery information relating to recovery timing at the trouble occurrence site and represented by an enabling function controlling a state transition of the stochastic time Petri net representing the evacuation sub-model; and
analysis means (120) for predicting time required for the evacuees to evacuate by analyzing the evacuation sub-model, the recovery sub-model, and the relation information.

2. The evacuation prediction system (100) according to claim 1, wherein
the model generating means (110) generates the evacuation sub-model with respect to each group of evacuees in a predetermined relation.

3. The evacuation prediction system (100) according to claim 1 or 2, wherein
the model generating means (110) generates the recovery sub-model with respect to each recovery plan for the trouble occurrence site.

4. The evacuation prediction system (100) according to any one of claims 1 to 3, wherein
the model generating means (110) generates the relation information so as to control a state transition relating to a movement of the evacuee in the evacuation sub-model in accordance with the recovery status of the trouble occurrence site in the recovery sub-model.

5. The evacuation prediction system (100) according to any one of claims 1 to 4, wherein
the model generating means (110) generates the models that represents at least one of time required for the evacuees to move or time related to recovery of the trouble occurrence site by a probability distribution.

6. The evacuation prediction system (100) according to any one of claims 1 to 5, wherein
the analysis means (120) predicts a distribution of the time required for the evacuee to evacuate.

7. A computer-implemented evacuation prediction method, comprising:
generating an evacuation sub-model representing evacuation paths that evacuees may pass in evacuation and a position of the evacuees on the evacuation paths and represented by a stochastic time Petri net, a recovery sub-model representing a recovery status at each of the trouble occurrence sites each of which is a site where a trouble occurred on the evacuation paths and represented by a stochastic time Petri net, and relation information representing a relation between the evacuation sub-model and the recovery sub-model based on information relating to the evacuation paths for the evacuees and information relating to recovery timing at the trouble occurrence site and represented by an enabling function controlling a state transition of the stochastic time Petri net representing the evacuation sub-model; and
predicting time required for the evacuees to evacuate by analyzing the evacuation sub-model, the recovery sub-model, and the relation information.

8. A computer-readable recording medium comprising instructions which, when executed by a computer, cause the computer to carry out:
generating an evacuation sub-model representing an evacuation paths that evacuees may pass in evacuation and a position of the evacuees on the evacuation paths and represented by a stochastic time Petri net, a recovery sub-model representing a recovery status at each of trouble occurrence sites each of which is a site where a trouble occurred on the evacuation paths and represented by a stochastic time Petri net, and relation information representing a relation between the evacuation sub-model and the recovery sub-model based on information relating to the evacuation paths for the evacuees and information relating to recovery timing at the trouble occurrence site and represented by an enabling function controlling a state transition of the stochastic time Petri net representing the evacuation sub-model; and
predicting time required for the evacuees to evacuate by analyzing the evacuation sub-model, the recovery sub-model, and the relation information.

## Patentansprüche

1. Evakuierungsvorhersagesystem (100), aufweisend:
Modellerzeugungseinrichtungen (110) zum Erzeugen
- eines durch ein stochastisches Zeit-Petri-Netz repräsentierten Evakuierungssubmodells, das Evakuierungspfade, die Betroffene bei einer Evakuierung nehmen können, und eine Position der Betroffenen auf den Evakuierungspfaden repräsentiert,
- eines durch ein stochastisches Zeit-Petri-Netz repräsentierten Bergungssubmodells, das einen Bergungsstatus an jedem von Problemauftretungsorten repräsentiert, von denen jeder ein Ort auf den Evakuierungspfaden ist, wo ein Problem auftrat, und
- einer Beziehungsinformation, die eine Beziehung zwischen dem Evakuierungssubmodell und dem Bergungssubmodell auf Basis einer Evakuierungsinformation betreffend die Evakuierungspfade für die Betroffenen und einer Bergungsinformation betreffend Bergungszeit an dem Problemauftretungsort repräsentiert und durch eine Ermöglichungsfunktion repräsentiert wird, die einen Statusübergang des das Evakuierungssubmodell repräsentierenden stochastischen Zeit-Petri-Netzes steuert; und
Analyseeinrichtungen (120) zum Vorhersagen einer Zeit, die die Betroffenen zur Evakuierung benötigen, durch Analysieren des Evakuierungssubmodells, des Bergungssubmodells und der Beziehungsinformation.

2. Evakuierungsvorhersagesystem (100) nach Anspruch 1, wobei die Modellerzeugungseinrichtungen (110) das Evakuierungssubmodell in Hinblick auf jede Gruppe Betroffener in einer vorgegebenen Beziehung erzeugt.

3. Evakuierungsvorhersagesystem (100) nach Anspruch 1 oder 2, wobei die Modellerzeugungseinrichtungen (110) das Bergungssubmodell in Hinblick auf jeden Bergungsplan für den Problemauftretungsort erzeugen.

4. Evakuierungsvorhersagesystem (100) nach einem der Ansprüche 1 bis 3, wobei die Modellerzeugungseinrichtungen (110) die Beziehungsinformation erzeugen, um so einen Statusübergang, der sich auf eine Bewegung der Betroffenen in dem Evakuierungssubmodell bezieht, in Übereinstimmung mit dem Bergungsstatus des Problemauftretungsorts in dem Bergungssubmodell zu steuern.

5. Evakuierungsvorhersagesystem (100) nach einem der Ansprüche 1 bis 4, wobei die Modellerzeugungseinrichtungen (110) die Modelle erzeugen, die eine Zeit, die die Betroffenen zur Fortbewegung benötigen, und/oder eine Zeit, die sich auf Bergung des Problemauftretungsorts bezieht, durch eine Wahrscheinlichkeitsverteilung repräsentieren.

6. Evakuierungsvorhersagesystem (100) nach einem der Ansprüche 1 bis 5, wobei die Analyseeinrichtungen (120) eine Verteilung der Zeit, die die Betroffenen für die Evakuierung benötigen, vorhersagen.

7. Computerimplementiertes Evakuierungsvorhersageverfahren, aufweisend:
Erzeugen
- eines durch ein stochastisches Zeit-Petri-Netz repräsentierten Evakuierungssubmodells, das Evakuierungspfade, die Betroffene bei der Evakuierung nehmen können, und eine Position der Betroffenen auf den Evakuierungspfaden repräsentiert,
- eines durch ein stochastisches Zeit-Petri-Netz repräsentierten Bergungssubmodells, das einen Bergungsstatus an jedem von Problemauftretungsorten repräsentiert, von denen jeder ein Ort auf den Evakuierungspfaden ist, wo ein Problem auftrat, und
- einer Beziehungsinformation, die eine Beziehung zwischen dem Evakuierungssubmodell und dem Bergungssubmodell auf Basis einer Information betreffend die Evakuierungspfade für die Betroffenen und einer Information betreffend Bergungszeit an dem Problemauftretungsort repräsentiert und durch eine Ermöglichungsfunktion repräsentiert wird, die einen Statusübergang des das Evakuierungssubmodell repräsentierenden stochastischen Zeit-Petri-Netzes steuert; und
Vorhersagen einer Zeit, die die Betroffenen zur Evakuierung benötigen, durch Analysieren des Evakuierungssubmodells, des Bergungssubmodells und der Beziehungsinformation.

8. Computerlesbares Aufzeichnungsmedium aufweisend Befehle, die, wenn sie von einem Computer abgearbeitet werden, den Computer veranlassen, folgende Schritte auszuführen:
Erzeugen
- eines durch ein stochastisches Zeit-Petri-Netz repräsentierten Evakuierungssubmodells, das Evakuierungspfade, die Betroffene bei der Evakuierung nehmen können, und eine Position der Betroffenen auf den Evakuierungspfaden repräsentiert,
- eines durch ein stochastisches Zeit-Petri-Netz repräsentierten Bergungssubmodells, das einen Bergungsstatus an jedem von Problemauftretungsorten repräsentiert, von denen jeder ein Ort auf den Evakuierungspfaden ist, wo ein Problem auftrat, und
- einer Beziehungsinformation, die eine Beziehung zwischen dem Evakuierungssubmodell und dem Bergungssubmodell auf Basis einer Information betreffend die Evakuierungspfade für die Betroffenen und einer Information betreffend Bergungszeit an dem Problemauftretungsort repräsentiert und durch eine Ermöglichungsfunktion repräsentiert wird, die einen Statusübergang des das Evakuierungssubmodell repräsentierenden stochastischen Zeit-Petri-Netzes steuert; und
Vorhersagen einer Zeit, die die Betroffenen zur Evakuierung benötigen, durch Analysieren des Evakuierungssubmodells, des Bergungssubmodells und der Beziehungsinformation.

## Revendications

1. Système de prédiction d'évacuation (100), comprenant :
un moyen de génération de modèle (110) pour générer un sous-modèle d'évacuation représentant des trajets d'évacuation que des évacués peuvent emprunter lors d'une évacuation et une position des évacués sur les trajets d'évacuation et représenté par un réseau de Petri stochastique temporel, un sous-modèle de rétablissement représentant un statut de rétablissement au niveau de chacun de sites de survenue de problème dont chacun est un site où un problème est survenu sur les trajets d'évacuation et représenté par un réseau de Petri stochastique temporel, et des informations de relation représentant une relation entre le sous-modèle d'évacuation et le sous-modèle de rétablissement sur la base d'informations d'évacuation relatives aux trajets d'évacuation pour les évacués et d'informations de rétablissement relatives à un minutage de rétablissement au niveau du site de survenue de problème et représenté par une fonction d'activation commandant une transition d'état du réseau de Petri stochastique temporel représentant le sous-modèle d'évacuation ; et
un moyen d'analyse (120) pour prédire un temps nécessaire pour l'évacuation des évacués par analyse du sous-modèle d'évacuation, du sous-modèle de rétablissement, et des informations de relation.

2. Système de prédiction d'évacuation (100) selon la revendication 1, dans lequel
le moyen de génération de modèle (110) génère le sous-modèle d'évacuation vis-à-vis de chaque groupe d'évacués dans une relation prédéterminée.

3. Système de prédiction d'évacuation (100) selon la revendication 1 ou 2, dans lequel
le moyen de génération de modèle (110) génère le sous-modèle de rétablissement vis-à-vis de chaque plan de rétablissement pour le site de survenue de problème.

4. Système de prédiction d'évacuation (100) selon l'une quelconque des revendications 1 à 3, dans lequel
le moyen de génération de modèle (110) génère les informations de relation de façon à commander une transition d'état relative à un déplacement de l'évacué dans le sous-modèle d'évacuation en conformité avec le statut de rétablissement du site de survenue de problème dans le sous-modèle de rétablissement.

5. Système de prédiction d'évacuation (100) selon l'une quelconque des revendications 1 à 4, dans lequel
le moyen de génération de modèle (110) génère les modèles qui représentent au moins l'un parmi un temps nécessaire pour le déplacement des évacués ou un temps relatif au rétablissement du site de survenue de problème par une distribution de probabilité.

6. Système de prédiction d'évacuation (100) selon l'une quelconque des revendications 1 à 5, dans lequel
le moyen d'analyse (120) prédit une distribution du temps nécessaire pour l'évacuation de l'évacué.

7. Procédé de prédiction d'évacuation mis en œuvre par ordinateur, comprenant :
la génération d'un sous-modèle d'évacuation représentant des trajets d'évacuation que des évacués peuvent emprunter lors d'une évacuation et une position des évacués sur les trajets d'évacuation et représenté par un réseau de Petri stochastique temporel, d'un sous-modèle de rétablissement représentant un statut de rétablissement au niveau de chacun des sites de survenue de problème dont chacun est un site où un problème est survenu sur les trajets d'évacuation et représenté par un réseau de Petri stochastique temporel, et d'informations de relation représentant une relation entre le sous-modèle d'évacuation et le sous-modèle de rétablissement sur la base d'informations relatives aux trajets d'évacuation pour les évacués et d'informations relatives à un minutage de rétablissement au niveau du site de survenue de problème et représenté par une fonction d'activation commandant une transition d'état du réseau de Petri stochastique temporel représentant le sous-modèle d'évacuation ; et
la prédiction d'un temps nécessaire pour l'évacuation des évacués par analyse du sous-modèle d'évacuation, du sous-modèle de rétablissement, et des informations de relation.

8. Support d'enregistrement lisible par ordinateur comprenant des instructions qui, lorsqu'elles sont exécutées par un ordinateur, amènent l'ordinateur à effectuer :
la génération d'un sous-modèle d'évacuation représentant des trajets d'évacuation que des évacués peuvent emprunter lors d'une évacuation et une position des évacués sur les trajets d'évacuation et représenté par un réseau de Petri stochastique temporel, d'un sous-modèle de rétablissement représentant un statut de rétablissement au niveau de chacun de sites de survenue de problème dont chacun est un site où un problème est survenu sur les trajets d'évacuation et représenté par un réseau de Petri stochastique temporel, et d'informations de relation représentant une relation entre le sous-modèle d'évacuation et le sous-modèle de rétablissement sur la base d'informations relatives aux trajets d'évacuation pour les évacués et d'informations relatives à un minutage de rétablissement au niveau du site de survenue de problème et représenté par une fonction d'activation commandant une transition d'état du réseau de Petri stochastique temporel représentant le sous-modèle d'évacuation ; et
la prédiction d'un temps nécessaire pour l'évacuation des évacués par analyse du sous-modèle d'évacuation, du sous-modèle de rétablissement, et des informations de relation.
